# EUROPÄISCHE PATENTSCHRIFT

(11) **EP 0 278 076 B1**
(45) Veröffentlichungstag und Bekanntmachung des Hinweises auf die Patenterteilung: **07.04.1993**
(21) Anmeldenummer: 87117249.0
(22) Anmeldetag: 24.11.1987
(51) Int. Cl.: G03F 1/00

(54) **Bestrahlungsmaske zur lithographischen Erzeugung von Mustern**
Lithographic mask for obtaining patterns
Masque lithographique pour l'obtention d'images

(30) Priorität: 06.02.1987 DE 3703582
(43) Veröffentlichungstag der Anmeldung: 17.08.1988
(73) Patentinhaber: Dr. Johannes Heidenhain GmbH, D-83292 Traunreut (DE)
(72) Erfinder: Kraus, Heinz, D-8225 Traunreut (DE)

(56) Entgegenhaltungen:
- US-A- 4 260 670
- PATENT ABSTRACTS OF JAPAN vol. 10, no. 232 (P-486)(2288) 12 August 1986 & JP-A-61 65250 (CANON INC.) 03 April 1986.

## Beschreibung

Die Erfindung betrifft eine Bestrahlungsmaske zur lithographischen Erzeugung von Mustern gemäß dem Oberbegriff des Anspruchs 1.

Eine derartige Bestrahlungsmaske dient insbesondere zur röntgenlithographischen oder ionenlithographischen Erzeugung von Halbleiterbausteinen und Halbleiterkomponenten sowie von optischen Gittern.

Aus der DE-OS 32 32 499 und der DE-OS 34 27 449 sind Bestrahlungsmasken für die röntgenlithographische Erzeugung von Mustern bekannt, bei denen in einem Tragrahmen eine strahlungsdurchlässige Trägerschicht mit einer strahlungsabsorbierenden, dem zu erzeugenden Muster entsprechenden Struktur angeordnet ist.

In der DE-OS 31 50 056 ist eine gleichartige Bestrahlungsmaske für die Röntgenlithographie oder die Ionenlithographie beschrieben. Der Tragrahmen für die strahlungsdurchlässige Trägerschicht weist Markierungen für die optische Ausrichtung der Bestrahlungsmaske bezüglich des zu bestrahlenden Halbleitersubstrats auf.

Die insbesondere mit der Röntgenlithographie erzielbare hohe Auflösung des zu erzeugenden Musters ist aber unabdingbar mit der Forderung nach äußerster Maßhaltigkeit der dem zu erzeugenden Muster entsprechenden Struktur der Bestrahlungsmaske verbunden.

Bei der Herstellung und bei der Verwendung einer solchen Bestrahlungsmaske treten aus verschiedenen Gründen, beispielsweise durch thermische Belastung der Trägerschicht mit der Struktur bei der Bestrahlung oder durch eine Verspannung der Trägerschicht mit der Struktur bei ihrer Befestigung im Tragrahmen, variable Spannungskomponenten auf, die zu nicht reproduzierbaren lateralen Verzerrungen der Trägerschicht führen können, so daß die Maßhaltigkeit der Struktur der Bestrahlungsmaske nicht mehr gewährleistet ist.

Der DE-OS 34 25 063 entnimmt man eine Bestrahlungsmaske für die Röntgenlithographie, bei der derartige laterale mechanische Verzerrungen durch eine spannungskompensierte Trägerschicht vermieden werden. Diese Trägerschicht besteht aus einer Siliziumschicht, die mit zwei unterschiedlichen Materialien für diese Spannungskompensation dotiert ist. Diese Spannungskompensation erfordert aber spezielle Materialien und ist fertigungstechnisch relativ aufwendig.

Aus den "Patent Abstracts of Japan" Vol. 10, Number 232 (P-486) (2288) vom 12. August 1986 ist es ferner bekannt, Bestrahlungsmasken herzustellen, die in ihrem Randbereich deformierbar sind, wobei diese Deformation elastisch ist, so daß der Maskenkörper selbst nicht deformiert wird. Die Herstellung dieser Bestrahlungsmaske, die ein Zusatzstück aufweist, ist relativ aufwendig.

Der Erfindung liegt die Aufgabe zugrunde, eine Bestrahlungsmaske der genannten Gattung anzugeben, bei der die Maßhaltigkeit der Struktur bei auftretenden Spannungskomponenten erhalten bleibt.

Diese Aufgabe wird erfindungsgemäß durch das kennzeichnende Merkmal des Anspruchs 1 gelöst.

Die mit der Erfindung erzielten Vorteile bestehen insbesondere darin, daß durch das Vorsehen eines elastischen Bereichs im Randbereich der Trägerschicht zweischen der Struktur und dem Tragrahmen auf einfache Weise eine Kompensation von auftretenden Spannungskomponenten erzielt wird. Die Ausbildung dieses elastischen Bereiches durch wenigstens zwei Reihen von Perforationen, die den Strukturbereich mit der Struktur umgeben, ist auf einfache Weise möglich, so daß sich kein fertigungstechnischer Aufwand ergibt; gleichfalls besteht keinerlei Beschränkung hinsichtlich der für die Trägerschicht geeigneten Materialien.

Vorteilhafte Ausbildungen entnimmt man den Unteransprüchen.

Ein Ausführungsbeispiel der Erfindung wird anhand der Zeichnung näher erläutert.

Es zeigen
- Figur 1: eine Bestrahlungsmaske im Querschnitt und
- Figur 2: die Bestrahlungsmaske in einer Draufsicht.

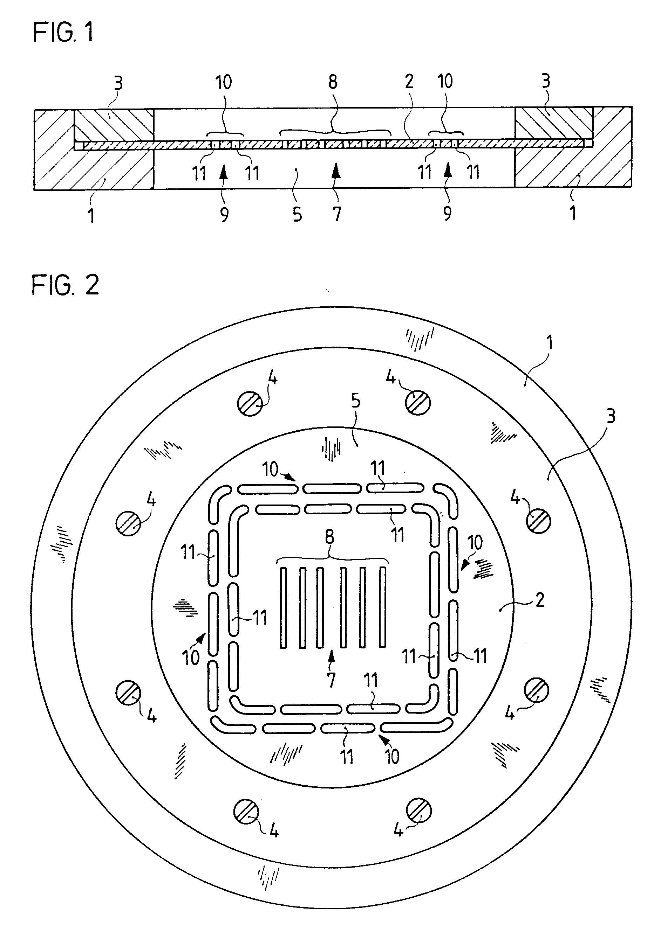

In Figur 1 ist eine Bestrahlungsmaske im Querschnitt und in Figur 2 in einer Draufsicht dargestellt. Diese Bestrahlungsmaske dient zur lithographischen Erzeugung von Mustern mit hoher Auflösung, insbesondere von optischen Gittern sowie von Halbleiterbauelementen und Halbleiterkomponenten durch Röntgenstrahllithographie oder Ionenstrahllithographie.

In einem kreisringförmigen Tragrahmen 1, beispielsweise aus Invar, ist eine strahlungsabsorbierende Trägerschicht 2, beispielsweise aus Nickel, durch einen Klemmring 3 mittels Schrauben 4 befestigt; diese Befestigung der Trägerschicht 2 im Tragrahmen 1 erfolgt mit einer gewissen Vorspannung gegen ein Durchhängen der Trägerschicht 2, um im Innenbereich 5 des Tragrahmens 1 einen ebenen Verlauf der Trägerschicht 2 zu gewährleisten.

Im Innenbereich 5 des Tragrahmens 1 besitzt die Trägerschicht 2 einen Strukturbereich 7 mit einer strahlungsdurchlässigen Struktur 8, die auf photolithographischem Wege gebildet ist.

Bei der Befestigung der Trägerschicht 2 im Tragrahmen 1 durch den Klemmring 3 können aber Spannungskomponenten in der Trägerschicht 2 auftreten, die zu nicht reproduzierbaren lateralen Verzerrungen in der Trägerschicht 2 führen können, so daß die Maßhaltigkeit der Struktur 8 im Strukturbereich 7 der Trägerschicht 2 der Bestrahlungsmaske nicht mehr gewährleistet ist. Derartige variable Spannungskomponenten können auch bei der Verwendung der Bestrahlungsmaske durch thermische Belastung der Trägerschicht 2 bei der Bestrahlung auftreten.

Zur Kompensation derartiger Spannungskomponenten wird erfindungsgemäß vorgeschlagen, daß die Trägerschicht 2 im Randbereich 9 zwischen dem Strukturbereich 7 mit der Struktur 8 und dem Tragrahmen 1 einen elastischen Bereich 10 aufweist. Dieser elastische Bereich 10 wird durch Perforationen 11 in der Trägerschicht 2 gebildet, die den Strukturbereich 7 mit der Struktur 8 wenigstens zweireihig umgeben. In den Figuren 1 und 2 umgeben in bevorzugter Ausbildung die Perforationen 11 den Strukturbereich 7 mit der Struktur 8 in zwei Reihen und sind in diesen beiden Reihen auf Lücke gegeneinander versetzt. Diese in Reihenrichtung längserstreckten Perforationen 11 bilden durch diese Konfiguration Federelemente, die den Strukturbereich 7 mit der Struktur 8 von den Spannungskomponenten isolieren, die vom Tragrahmen 1 und dem Klemmring 3 ausgehen.

In nicht dargestellter Weise kann die Bestrahlungsmaske auch eine strahlungsdurchlässige Trägerschicht aufweisen, auf der eine strahlungsabsorbierende Struktur vorgesehen ist; eine solche Bestrahlungsmaske ist beispielsweise in der DE-OS 34 27 449 beschrieben.

## Patentansprüche

1. Bestrahlungsmaske zur lithographischen Erzeugung von Mustern, bei der in einem Tragrahmen eine Trägerschicht mit einer dem zu erzeugenden Muster entsprechenden Struktur angeordnet ist, dadurch gekennzeichnet, daß die Trägerschicht (2) im Randbereich (9) zwischen der Struktur (8) und dem Tragrahmen (1) einen elastischen Bereich (10) aufweist, der durch Perforationen (11) in der Trägerschicht (2) gebildet ist.

2. Bestrahlungsmaske nach Anspruch 1, dadurch gekennzeichnet, daß die Perforationen (11) die Struktur (8) in wenigstens zwei Reihen umgeben.

3. Bestrahlungsmaske nach Anspruch 2, dadurch gekennzeichnet, daß die Perforationen (11) wenigstens zweier benachbarter Reihen gegeneinander versetzt sind.

4. Bestrahlungsmaske nach Anspruch 1, dadurch gekennzeichnet, daß in der strahlungsabsorbierenden Trägerschicht (2) die strahlungsdurchlässige Struktur (8) angeordnet ist.

5. Bestrahlungsmaske nach Anspruch 1, dadurch gekennzeichnet, daß auf einer strahlungsdurchlässigen Trägerschicht eine strahlungsabsorbierende Struktur angeordnet ist.

## Claims

1. Lithographic mask for lithographic production of patterns, in which a carrier layer with a structure corresponding to the pattern to be produced is disposed in a carrier frame, characterised in that the carrier layer (2) has, in the edge region (9) between the structure (8) and the carrier frame (1), a resilient region (10), formed by perforations (11) in the carrier layer (2).

2. Lithographic mask according to claim 1, characterised in that the perforations (11) surround the structure (8) in at least two rows.

3. Lithographic mask according to claim 2, characterised in that the perforations (11) of at least two adjacent rows are offset to one another.

4. Lithographic mask according to claim 1, characterised in that the radiation-permeable structure (8) is disposed in the radiation-absorbing carrier layer (2).

5. Lithographic mask according to claim 1, characterised in that a radiation-absorbing structure is disposed on a radiation-permeable carrier layer.

## Revendications

1. Masque d'exposition pour la réalisation par lithographie de dessins, lequel masque comporte, à l'intérieur d'un cadre-support, une couche-support portant une structure correspondant au dessin à réaliser, caractérisé par le fait que la couche-support (2) est pourvue dans la région du bord (9), entre la structure (8) et le cadre-support (1), d'une zone élastique (10) qui est réatisée par des perforations (11) dans la couche-support (2).

2. Masque d'exposition selon la revendication 1, caractérisé par le fait que les perforations (11) entourent sur au moins deux rangées la structure (8).

3. Masque d'exposition selon la revendication 2, caractérisé par le fait que les perforations (11) d'au moins deux rangées voisines sont décalées les unes par rapport aux autres.

4. Masque d'exposition selon la revendication 1, caractérisé par le fait que la structure (8) laissant passer le rayonnement est disposée à l'intérieur de la couche-support (2) absorbant le rayonnement.

5. Masque d'exposition selon la revendication 1, caractérisé par le fait qu'une structure absorbant le rayonnement est disposée sur une couche-support laissant passer le rayonnement.
